# FASCICULE DE BREVET EUROPEEN

(11) **EP 3 290 935 B1**
(45) Date de publication et mention de la délivrance du brevet: **06.10.2021**
(21) Numéro de dépôt: 17188641.9
(22) Date de dépôt: 30.08.2017
(51) Int. Cl.: G01R 31/327, H01H 71/02, H02H 1/06

(54) **UNITÉ DE CONTRÔLE D'UN DISJONCTEUR ÉLECTRIQUE ET DISJONCTEUR COMPORTANT UNE TELLE UNITÉ DE CONTRÔLE**
KONTROLLEINHEIT EINES ELEKTRISCHEN TRENNSCHALTERS, UND TRENNSCHALTER, DER EINE SOLCHE KONTROLLEINHEIT UMFASST
CONTROL UNIT OF AN ELECTRICAL CIRCUIT BREAKER AND CIRCUIT BREAKER COMPRISING SUCH A CONTROL UNIT

(30) Priorité: 31.08.2016 FR 1658076
(43) Date de publication de la demande: 07.03.2018
(73) Titulaire: Schneider Electric Industries SAS, 92500 Rueil-Malmaison (FR)
(72) Inventeur: MARTIN, Willy, 38050 GRENOBLE Cedex 09 (FR); OURTH, Thierry, 38050 GRENOBLE Cedex 09 (FR); THERON, Olivier, 38050 GRENOBLE Cedex 09 (FR); DELETANG, Théo, 38050 GRENOBLE Cedex 09 (FR); LABABSA, Vincent, 38050 GRENOBLE Cedex 09 (FR); PRIEUR, Patrick, 38050 GRENOBLE Cedex 09 (FR)
(74) Mandataire: Lavoix

(56) Documents cités:
- EP-A1- 2 079 091
- EP-A1- 2 590 198
- EP-A1- 2 822 018
- EP-A1- 3 018 691
- US-A- 5 331 500
- US-A- 5 945 650
- US-B1- 6 329 810

## Description

L'invention concerne unité de contrôle d'un disjoncteur électrique multipolaire.

On connaît des disjoncteurs électriques comportant une unité de contrôle électronique. Une telle unité de contrôle est typiquement programmée pour mesurer en temps réel un état de fonctionnement du disjoncteur et pour commander l'ouverture du disjoncteur en cas d'un défaut de fonctionnement du disjoncteur. Une telle unité de contrôle comporte un module d'alimentation électrique pourvu d'un convertisseur de puissance, qui est alimenté électriquement depuis des terminaux d'entrée du disjoncteur, de manière à collecter des tensions électriques primaires associées au courant électrique qui traverse le disjoncteur. Ce convertisseur de puissance est en outre adapté pour transformer ces tensions électriques primaires en une tension électrique secondaire qui sert à alimenter électriquement le dispositif de commande. Le document EP 3 018 691 A1 divulgue une unité de contrôle connue.

Ces unités de contrôle connues ont pour inconvénient qu'il n'est pas possible de retirer le module d'alimentation électrique comprenant des circuits de puissance, sans impacter négativement le fonctionnement de l'unité de contrôle du disjoncteur. Cela complique la réalisation d'opérations de maintenance en cas de défaillance, ce qui réduit la fiabilité de l'unité de contrôle.

C'est à ces inconvénients qu'entend plus particulièrement remédier l'invention, en proposant une unité de contrôle d'un disjoncteur électrique multipolaire présentant un aspect modulaire, dans lequel le module d'alimentation électrique peut être retiré ou remplacé, sans nuire au fonctionnement de l'unité de contrôle du disjoncteur au cours du temps, tout en garantissant une bonne sécurité électrique de l'unité de contrôle.

A cet effet, l'invention concerne une unité de contrôle d'un disjoncteur électrique multipolaire comportant :
- un corps central incluant :
   - un dispositif d'interconnexion comprenant :
      o des plots de contact d'entrée apte à être raccordées électriquement à des terminaux d'entrée de puissance d'un disjoncteur électrique multipolaire, pour recevoir des tensions électriques primaires depuis le disjoncteur,
      o un circuit électrique de puissance incluant un pont diviseur de tension, configuré pour convertir les tensions électriques primaires en des tensions électriques secondaires;
   - un dispositif de commande, pourvu d'un circuit de mesure apte à mesurer les tensions électriques secondaires fournies par le circuit électrique de puissance, le dispositif de commande étant programmé pour déterminer un état de fonctionnement du disjoncteur en fonction des tensions électriques secondaires mesurées par le circuit de mesure ;
- un module d'alimentation électrique amovible, reçu dans un logement du corps central, ce module :
   - étant raccordé électriquement au dispositif d'interconnexion pour collecter les tensions électriques primaires, et
   - comprenant un convertisseur de puissance, configuré pour transformer les tensions électriques primaires collectées en une tension électrique secondaire supplémentaire et pour alimenter électriquement un bus commun d'alimentation électrique du dispositif de commande avec cette tension électrique secondaire supplémentaire.

Grâce à l'invention, le module d'alimentation peut être retiré sans impacter le fonctionnement du dispositif de commande, notamment sans empêcher ce dernier d'assurer une supervision du fonctionnement du disjoncteur. Une telle structure modulaire permet de remplacer un module d'alimentation défaillant sans avoir à remplacer la totalité de l'unité de contrôle. Ceci est rendu possible par le fait que le circuit électrique de puissance, qui assure le conditionnement des tensions électriques secondaires utilisées par le circuit de mesure, est distinct du convertisseur de puissance qui équipe le module d'alimentation électrique amovible.

En outre, le dispositif d'interconnexion assure une isolation électrique satisfaisante entre les parties de l'unité de contrôle qui sont en contact avec les tensions primaires de celles qui sont en contact avec les tensions secondaires.

Selon des aspects avantageux mais non obligatoires de l'invention, l'unité de contrôle comporte une ou plusieurs des caractéristiques suivantes, prises selon toute combinaison techniquement admissible :
- Le dispositif d'interconnexion comporte un support sur lequel le circuit électrique de puissance est ménagé, les plots de contact d'entrée étant disposés au niveau d'un bord du support, et en ce que le dispositif d'interconnexion comporte des écrans d'isolement longitudinaux arrangés le long du support en partant depuis ledit bord du support et en s'étendant perpendiculairement par rapport au plan du support, pour séparer transversalement les plots de contacts d'entrée les uns des autres ;
- Les écrans d'isolement longitudinaux s'étendent sur au moins 50% de la longueur du support ;
- Le pont diviseur comporte des résistances électriques reliées électriquement entre elles, le long de rangées pour former des branches distinctes du circuit électrique de puissance, chaque branche étant associée à une phase électrique, les écrans d'isolement longitudinaux s'étendent parallèlement aux rangées de résistances pour séparer transversalement ces branches les unes des autres ;
- L'unité comporte un connecteur fil-à-carte amovible pour raccorder électriquement les plots de contact d'entrée à des câbles électriques aptes à être raccordés électriquement à des terminaux d'entrée de puissance du disjoncteur, ce connecteur fil-à-carte comportant un boîtier dans lequel sont ménagés des logements, à l'intérieur desquels sont reçus les plots de contact d'entrée lorsque le connecteur est dans une position connectée au dispositif d'interconnexion, ces logements étant séparés les uns des autres sur une partie de leur longueur par des espacements extérieurs de forme complémentaire aux écrans d'isolement longitudinaux ;
- Le dispositif d'interconnexion comporte :
   - des plots de contact de sortie du circuit électrique de puissance, ménagés sur une même face du support que les plots de contact d'entrée, et
   - un mur d'isolement intercalé entre les plots de contact d'entrée et les plots de contact de sortie et s'étendant perpendiculairement à ladite face ;
- Le dispositif d'interconnexion comporte des connecteurs électriques unitaires à lame souple adaptés pour être raccordés électriquement à une interface de connexion primaire du module d'alimentation amovible ;
- Les connecteurs unitaires à lame souple sont réalisés en un alliage de Cuivre ― Béryllium ;
- L'unité de contrôle comporte des modules additionnels amovibles aptes à être raccordés électriquement au dispositif de commande, l'unité de contrôle comportant à cet effet des connecteurs électriques à pistons adaptés pour être connectés à des connecteurs correspondants équipant ces modules additionnels ;

Selon un autre aspect, l'invention concerne enfin un disjoncteur électrique multipolaire comportant une unité de contrôle conforme à l'invention, le dispositif d'interconnexion étant raccordé électriquement à des terminaux de puissance du disjoncteur.

L'invention sera mieux comprise et d'autres avantages de celle-ci apparaîtront plus clairement à la lumière de la description qui va suivre, d'un mode de réalisation d'une unité de contrôle d'un disjoncteur électrique multipolaire, donné uniquement à titre d'exemple et faite en référence aux dessins annexés, dans lesquels:
- la figure 1 est une représentation schématique, selon une vue éclatée, d'une unité de contrôle d'un disjoncteur électrique multipolaire conforme à l'invention ;
- la figure 2 est une représentation schématique, selon une vue en coupe, de l'unité de contrôle de la figure 1 dans une configuration assemblée ;
- la figure 3 est un schéma synoptique simplifié du fonctionnement d'un ensemble électrique comportant l'unité de contrôle des figures 1 et 2 ;
- la figure 4 est une représentation schématique, selon une vue en perspective, d'un dispositif d'interconnexion inclus dans un corps central de l'unité de contrôle des figures 1 et 2 ;
- la figure 5 est une représentation schématique d'une première face du dispositif d'interconnexion de la figure 4 ;
- la figure 6 est une vue rapprochée du dispositif d'interconnexion de la figure 4 sur lequel est monté un connecteur fil à carte illustré sur une vue écorchée ;
- la figure 7 est une représentation schématique, selon une vue rapprochée, d'un bord du dispositif d'interconnexion de la figure 5 ;
- la figure 8 est une représentation schématique, d'une deuxième face opposée du dispositif d'interconnexion de la figure 5 ;
- la figure 9 est une représentation schématique, selon une vue rapprochée, d'un connecteur électrique du dispositif d'interconnexion de la figure 8.

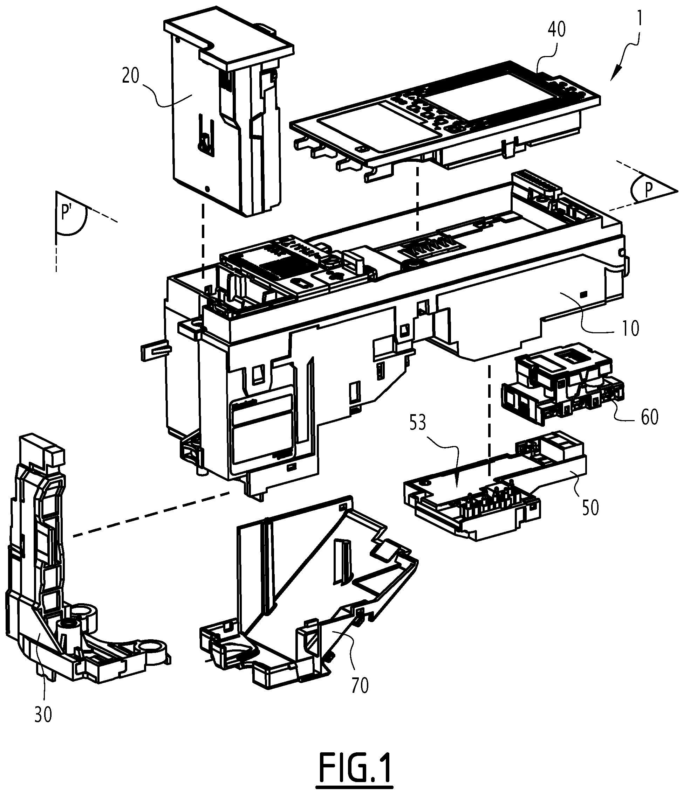

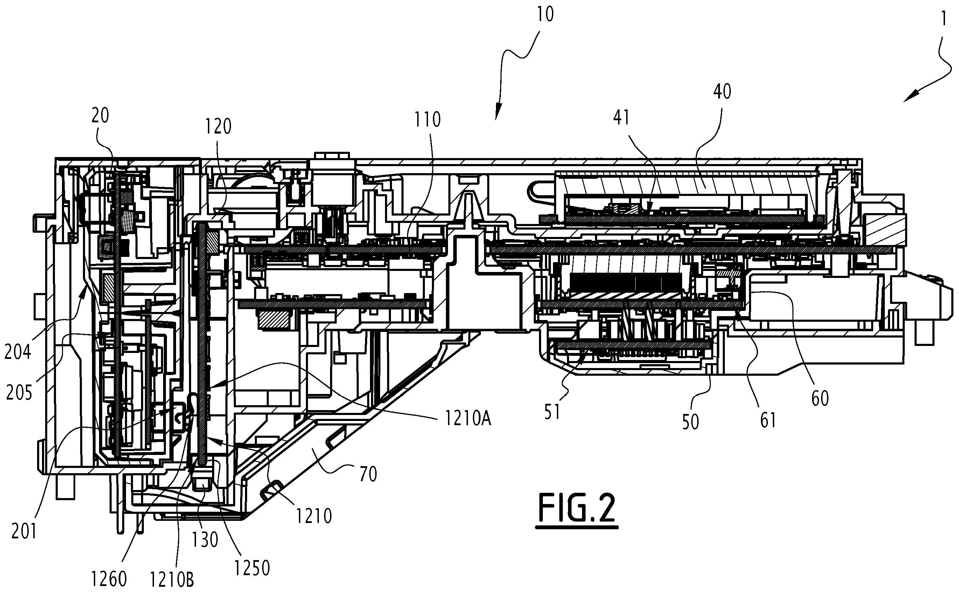

Les figures 1 et 2 représentent une unité de contrôle 1 pour un disjoncteur multipolaire.

De façon connue, un disjoncteur électrique multipolaire comporte, pour chaque pôle électrique, des terminaux d'entrée et de sortie de puissance, qui sont sélectivement raccordés ou isolés électriquement l'un de l'autre par des contacts mobiles séparables du disjoncteur.

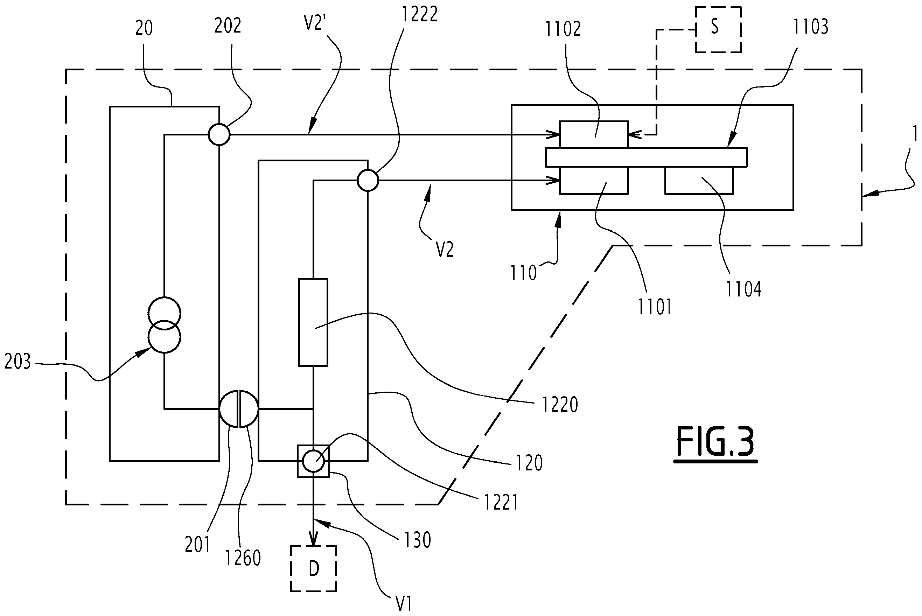

L'unité 1 est destinée à être associé à un tel disjoncteur D, visible à la figure 3, pour commander l'ouverture du disjoncteur, c'est-à-dire la séparation des terminaux d'entrée et de sortie de puissance de chaque pôle, en cas de détection d'une anomalie de fonctionnement telle qu'une surintensité ou un court-circuit, afin d'empêcher la circulation du courant électrique entre ces terminaux.

Dans cet exemple, l'unité 1 est associée au disjoncteur D pour former un ensemble électrique. Le disjoncteur D comporte alors l'unité 1.

Avantageusement, l'unité de contrôle 1 est également configurée pour mesurer des grandeurs physiques représentatives du courant qui circule dans le disjoncteur D, en vue d'établir des statistiques sur le fonctionnement du disjoncteur D, par exemple déterminer des courants électriques, des tensions électriques, des puissances électriques ou énergies instantanées ou encore dénombrer le nombre de cycles d'ouverture/fermeture du disjoncteur D.

A cet effet, l'unité 1 est adaptée pour être connecté électriquement aux terminaux d'entrée du disjoncteur D.

Dans cet exemple, le disjoncteur D est un disjoncteur multipolaire configuré pour fonctionner avec un courant électrique alternatif polyphasé, par exemple triphasé. Ainsi, dans cet exemple, le disjoncteur D comporte trois pôles électriques respectivement associés à des phases électriques P1, P2 et P3, ainsi qu'un pôle électrique associé à une phase neutre PN.

L'unité de contrôle 1 comporte un corps central 10 et plusieurs modules amovibles 20, 30, 40, 50, 60 et 70. En variante, le nombre de modules peut être différent. Chacun de ces modules est apte à remplir une fonction particulière prédéfinie, expliquée plus en détail dans ce qui suit. Chacun des modules amovibles 20, 30, 40, 50, 60 et 70 est déplaçable entre une position insérée dans le corps central 10 et une position retirée du corps central 10.

Dans la position insérée, le module amovible est reçu dans un logement correspondant du corps central 10 ou dans un logement correspondant d'un autre module amovible lui-même déjà reçu dans le corps central 10. Le module amovible est alors raccordé électriquement à des composants de l'unité 1 contenus dans le corps central 10.

Dans la position retirée, le module amovible est en dehors du corps central 10 et n'est pas électriquement raccordé à un composant de l'unité 1 contenu dans le corps central 10.

Comme illustré à la figure 3, le corps central 10 comporte un dispositif de commande 110 et un dispositif d'interconnexion 120.

Le dispositif de commande 110 est configuré pour mesurer l'état de fonctionnement du disjoncteur D, et notamment la valeur de courant qui circule au cours du temps dans ce disjoncteur D, et pour déclencher l'ouverture du disjoncteur D lorsqu'une anomalie de fonctionnement est détectée lors de cette mesure.

Le dispositif de commande 110 comporte un circuit de mesure 1101, un bus d'alimentation électrique commun 1102, et une unité de calcul de traitement du signal 1104, qui sont ici ménagés sur une carte électronique 1103 du dispositif de commande 110.

La carte électronique 1103 comporte un support rigide, par exemple du type PCB pour « Printed Circuit Board » en langue anglaise. Cette carte électronique 1103 s'étend essentiellement selon un plan géométrique P.

Dans cet exemple, la carte électronique 1103 s'étend sur toute la longueur du dispositif de commande 110 et du corps central 10, ce dernier présentant une forme oblongue selon le plan géométrique P. Dans une configuration assemblée de l'unité de contrôle 1 avec le disjoncteur D, le plan géométrique P s'étend parallèlement à une face avant du disjoncteur D, selon une direction verticale.

Le circuit de mesure 1101 est adapté pour mesurer la valeur d'une tension électrique qui est fournie sur une de ses entrées et, en réponse, délivrer un signal représentatif de la valeur de tension mesurée à destination de l'unité de calcul 1104.

L'unité de calcul 1104 est programmée pour déterminer automatiquement un état de fonctionnement du disjoncteur à partir de la valeur de tension mesurée. Par exemple, l'unité de calcul 1104 commande l'ouverture du disjoncteur D, si la valeur de tension mesurée est supérieure à un seuil prédéfini, indiquant un défaut de sécurité, telle qu'une surtension ou baisse de tension au niveau du disjoncteur D. L'unité de calcul 1104 comporte ici un microcontrôleur programmable.

Par exemple, la commande du disjoncteur D par l'unité de commande 110 est réalisée grâce à une liaison filaire, non illustrée, entre l'unité de commande 110 et une interface dédiée du disjoncteur D.

Le bus d'alimentation électrique commun 1102 est configuré pour distribuer une alimentation électrique aux différents éléments du circuit de commande 110, tel que le circuit de commande 1101 ou l'unité de calcul 1104. Le bus d'alimentation 1102 est également configuré pour distribuer une alimentation électrique à destination des modules additionnels 30, 40, 50 et 60 afin d'en assurer le fonctionnement lorsque ceux-ci sont en position insérée.

Le dispositif d'interconnexion 120 est configuré pour être raccordé électriquement au disjoncteur D, de manière à collecter des tensions électriques primaires V1 en provenance du disjoncteur D associées aux terminaux de puissance du disjoncteur D. Ce raccordement est ici réalisé au moyen d'un connecteur fil-à-carte 130.

Dans cette description, on note « tension électrique primaire » des tensions électriques dont l'amplitude maximale est supérieure ou égale à 100 volts ou à 240 volts ou à 400 volts .Ces tensions électriques primaires correspondent à celles provenant du disjoncteur D.

A titre illustratif, dans cet exemple, le disjoncteur D est un disjoncteur à basse tension et à haute intensité adapté pour fonctionner avec des tensions électriques d'amplitude maximale inférieure ou égale à 690 Volts AC. Ici, ces tensions primaires V1 sont des différences de potentiel électrique entre deux phases du courant électrique polyphasé et sont donc elles-mêmes polyphasées.

Dans cette description, le terme « tension électrique secondaire » désigne une tension électrique, alternative ou continue, dont l'amplitude maximale est inférieure ou égale à 20 Volts ou à 30 Volts.

Typiquement, les tensions primaires V1 issues du disjoncteur D lors de son fonctionnement sont trop élevées pour alimenter directement le dispositif de commande 110. Ainsi, le circuit de mesure 1101 ne peut pas recevoir en entrée directement les tensions primaires V1. Les tensions primaires V1 doivent donc être préalablement transformées en tension secondaire. De plus, les tensions primaires, du fait de leur valeur élevée, présentent un risque de sécurité électrique pour un utilisateur de l'unité 1 si ce dernier entre en contact avec elles.

Le dispositif d'interconnexion 120 a donc également pour fonction d'être raccordé électriquement au disjoncteur D pour collecter les tensions primaires V1 et pour générer des tensions secondaires V2 à partir de ces tensions primaires V1 et de fournir les tensions secondaires V2 générées au circuit de mesure 1101. En outre, le dispositif d'interconnexion 120 a pour fonction de partager ces tensions primaires V1 collectées avec le module d'alimentation amovible 20, lorsque ce dernier est en position insérée dans le corps central 10.

Le module d'alimentation 20 est quant à lui configuré pour convertir les tensions primaires V1 en une tension secondaire additionnelle V2', aussi nommée tension électrique secondaire supplémentaire, d'alimentation du dispositif de commande 110. La tension secondaire additionnelle V2' n'est pas nécessairement identique à la tension électrique secondaire V2 fournie par le dispositif d'interconnexion 120.

A cet effet, le module d'alimentation amovible 20 comporte une interface de connexion primaire 201, une interface de connexion secondaire 202, un convertisseur de puissance 203 qui sont ici fixés sur un support rigide 205 (Figure 2) et logés à l'intérieur d'un boîtier 204 (Figure 2) du module d'alimentation amovible 20.

Le support 205 présente ici une forme plane et s'étend dans un plan géométrique P' perpendiculaire au plan géométrique P. Le plan géométrique P' correspond à un plan horizontal lorsque l'unité 1 est dans une configuration assemblée avec le disjoncteur D.

Le convertisseur de puissance 203 est adapté pour transformer une tension primaire V1 reçue depuis l'interface de connexion primaire 201 en tension secondaire additionnelle V2', qui est ensuite délivrée vers l'interface de connexion secondaire 202. Par exemple, le convertisseur de puissance 203 est un transformateur de tension.

Dans cet exemple, le bus d'alimentation 1102 est configuré pour être alimenté par une tension secondaire additionnelle V2' continue d'amplitude égale à 24 Volts. Avantageusement, le bus d'alimentation 1102 comporte des convertisseurs de puissance additionnels adaptés pour transformer cette tension secondaire additionnelle V2' en une tension continue de valeur inférieure, par exemple égale à 3,3 Volts, en vue d'alimenter certains éléments du dispositif de commande 110.

Lorsque le module d'alimentation amovible 20 est en position insérée dans le corps central 10, les interfaces de connexion primaire 201 et secondaire 202 sont connectées, respectivement, au dispositif d'interconnexion 120 et au dispositif de commande 110. Au contraire, dans la position retirée, les interfaces de connexion primaire 201 et secondaire 202 sont déconnectées, respectivement, du dispositif d'interconnexion 120 et de dispositif de commande 110.

Le bus d'alimentation 1102 est adapté pour être approvisionné avec une tension secondaire fournie par le module 20 lorsque ce dernier est en position insérée. Toutefois, le bus 1102 est avantageusement adapté pour continuer à être approvisionné en énergie lorsque le module 20 est retiré du corps central 10.

Par exemple, cet approvisionnement est réalisé par le module d'alimentation 20 lorsque ce dernier est présent au sein de l'unité 1. Toutefois, le bus d'alimentation 1102 est également adapté pour être approvisionné par une tension électrique en provenance de source d'alimentation auxiliaire S (figure 3). Ces sources d'alimentation auxiliaires S peuvent être utilisées en complément ou en remplacement du module d'alimentation.

Un premier exemple de source d'alimentation auxiliaire S est un capteur de courant intégré au sein du disjoncteur, tel qu'un transformateur de courant, qui génère une tension électrique à partir du courant électrique de puissance qui circule au sein du disjoncteur. Une telle source, de façon connue, fonctionne que lorsque le disjoncteur est dans l'état fermé et qu'un courant électrique circule entre les terminaux d'entrée et de sortie du disjoncteur.

Un deuxième exemple de source d'alimentation auxiliaire S est une batterie de secours incorporée au sein de l'unité de contrôle 1 et non illustrée.

Un troisième exemple de source d'alimentation auxiliaire S peut être un module d'alimentation auxiliaire relié à une alimentation électrique extérieure, par exemple en provenance du tableau électrique dans lequel l'unité 1 et le disjoncteur D sont installés. Cette source électrique pouvant être associée à un onduleur ou à une alimentation de secours.

Un quatrième exemple de source d'alimentation auxiliaire S est fourni par un utilisateur de l'unité 1, au moyen d'une liaison de données USB, pour « Universal Serial Bus » en langue anglaise, par exemple lorsque cet utilisateur connecte au dispositif de commande 110 un terminal informatique pour réaliser des opérations de diagnostic de maintenance de l'unité de contrôle 1.

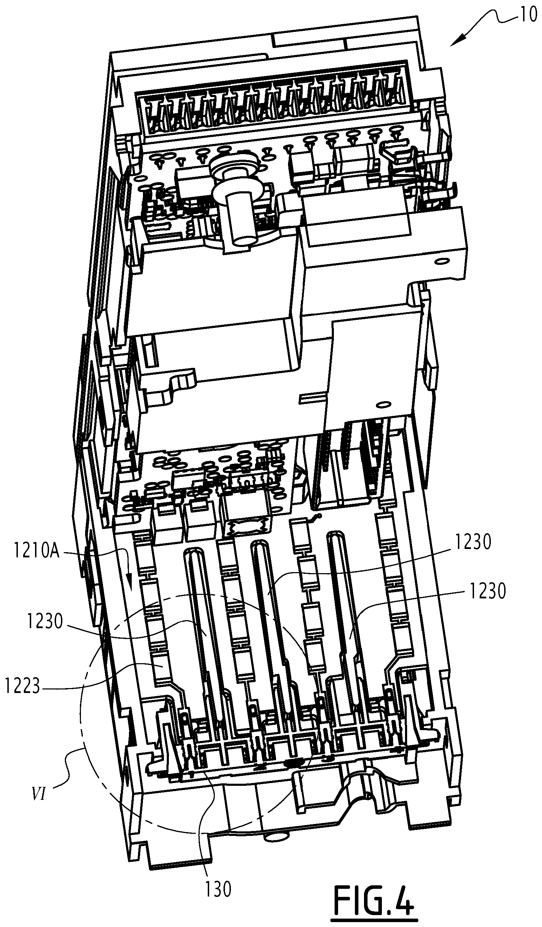

Les figures 4 à 9 illustrent plus en détail le dispositif d'interconnexion 120.

Comme illustré aux figures 3 et 4, le dispositif d'interconnexion 120 comporte des plots de contact d'entrée 1221 aptes à être raccordés électriquement à des plots terminaux d'entrée de puissance du disjoncteur électrique multipolaire D pour recevoir les tensions électriques primaires depuis le disjoncteur D. Par exemple, le dispositif d'interconnexion 120 comporte quatre plots de contact d'entrée 1221 chacun associé à l'une des phases électriques P1, P2, P3 et à la phase neutre PN.

Cette interconnexion avec les terminaux d'entrée du disjoncteur D est réalisée au moyen d'un connecteur fil-à-carte 130 qui est décrit dans ce qui suit.

Le dispositif d'interconnexion 120 comporte également des plots de contact de sortie 1222 raccordés électriquement au circuit de mesure 1001 au moyen de connexions filaires, non illustrées.

Le dispositif d'interconnexion 120 comporte en outre un circuit électrique de puissance 1220, raccordé entre les plots de contact d'entrée 1221 et les plots de contact de sortie 1222. Ce circuit électrique de puissance 1220 est ici un pont diviseur de tension formé par une pluralité de résistances électriques 1223 et 1223'.

Le dispositif de connexion 120 comporte ici un support 1210 de forme plane sur lequel est formé le circuit électrique de puissance 1220, les plots de contact d'entrée 1221 et les plots de contact de sortie 1122. Par exemple, le support 1210 est rigide.

Le support 1210 s'étend ici dans le plan géométrique P'. On note « 1210A » une première face du support 1210 et « 1210B » une deuxième face du support 1210, qui est opposée à la première face 1210A.

Les plots de contact d'entrée 1221 sont ménagés sur la première face 1210A, au niveau d'un bord du support 1210. Les plots de contact de sortie 1222 sont également formés sur la première face 1210A, à un emplacement distinct de celui des plots de contact d'entrée 1221.

Les résistances 1223 sont disposées sur la première face 1210A, alors que les résistances 1223' sont disposées sur la deuxième face 1210B. Les résistances 1223 et 1223' sont ici identiques.

Les résistances 1223 sont disposées de façon à former des branches du pont diviseur du circuit de puissance 1220, chacune associée à une des phases électriques P1, P2, P3 et PN. Plus précisément, les résistances 1223 et 1223' sont, au sein de chaque branche du circuit de puissance 1220, raccordées électriquement entre elles ainsi qu'aux plots de contact d'entrée 1221 et de sortie 1222 au moyen de pistes électriquement conductrice ménagée sur les première et deuxième faces 1210A et 1210B correspondantes du support 1210. La position de chaque résistance 1223, 1223' permet de garantir un isolement électrique entre elles et entre chaque branche.

Dans cet exemple, le support 1210 comporte une partie principale depuis laquelle s'étendent quatre prolongements longitudinaux, ou branches, parallèles entre eux et séparés par des espacements 1210E, de sorte à ce que le support 1210 présente une forme de E à quatre branches. Chacune des branches est associée à une phase électrique du circuit P1, P2, P3 et PN. Ainsi, chaque branche comporte un unique plot de contact d'entrée 1221 et comporte également les résistances 1223 associées à cette phase électrique. Les plots de contact de sortie 1222 sont disposés les uns à côté des autres au niveau de la partie principale du support 1210.

De préférence, la phase neutre PN est associée à une des branches centrale du support 1210 et non pas placé sur une des branches qui se situent sur des bords extérieurs du support 1210. De cette manière, il y a au moins deux phases électriques P1, P2 et P3 distinctes qui sont séparées l'une de l'autre par la phase neutre PN, ce qui améliore la sécurité électrique, notamment vis-à-vis de la formation d'arc électrique entre les connecteurs de ces différentes phases.

Dans cet exemple, cinq ou six résistances 1223, 1223' sont utilisées pour chacune des phases électriques P1, P2, P3 et PN. En variante, ce nombre peut être différent. En particulier, les résistances 1223' qui sont disposées sur la deuxième face 1210B peuvent être omises. Elles sont typiquement disposées sur cette face 1210B lorsqu'il n'y a pas assez de place sur la première face 1210A pour les accueillir.

Par exemple, le support 1210 présente une longueur D1 égale à 40mm et une largeur D2 égale à 54mm. Cette longueur et cette largeur sont ici mesurées dans le plan du support 1210.

Le dispositif d'interconnexion 110 comporte également des cloisons, ou écrans isolants longitudinaux 1230, qui sont arrangés le long de la face 1210A du support 1210, en partant depuis le bord du support 1210 et en s'étendant perpendiculairement par rapport au support 1210. Ces écrans longitudinaux 1230 sont ici au nombre de trois et sont identiques entre eux.

Avantageusement, la hauteur de chaque écran 1230 est supérieure ou égale à 8 mm ou à 8.5 mm,

Avantageusement, les écrans d'isolement 1230 s'étendent sur au moins 50% de la longueur du support 1210, de préférence au moins 80% la longueur du support 1210.

Ces écrans d'isolement 1230 sont réalisés en un matériau électriquement isolant haute température et ignifugé, par exemple en matière plastique telle que du polyamide réticulé, ou du polycarbonate chargé fibre de verre. Par exemple, on utilise du polyamide réticulé 6.6, aussi noté « PA 6.6 », ou du Polycarbonate PC GF10.

Dans cet exemple, les écrans 1230 sont solidaires à un boîtier du corps central 10. Chaque écran d'isolement 1230 est reçu à l'intérieur d'un évidement 1210E du support 1210 qui sépare les branches parallèles du support 1210. Ainsi, dans cet exemple, les écrans 1230 sont distincts du support 1210.

En variante, toutefois, les écrans 1230 peuvent être ménagés directement sur le support 1210.

Les écrans d'isolement 1230 présentent ainsi une forme complémentaire à celle des espacements 1210E du support 1210.

Ainsi, les écrans 1230 séparent transversalement les plots de contact d'entrée 1221 les uns des autres. En outre, du fait que ces écrans 1230 s'étendent sur la longueur du support 1210, ils séparent transversalement les unes des autres les rangées de résistances 1223 du circuit de puissance 1220 qui sont ménagées sur la face 1210A.

Les écrans longitudinaux 1230 créent ainsi une barrière électriquement isolante qui s'intercale entre les plots de contact d'entrée 1221 associés aux phases électriques P1, P2, P3 et PN et qui augmente la distance point à point entre ces plots de contact d'entrée 1221.

De plus, du fait de leur longueur, les écrans longitudinaux 1230 augmentent la distance de ligne de fuite entre ces plots de contact d'entrée 1221. Il en va de même vis-à-vis des branches du circuit de puissance 1220.

Ainsi, on réduit le risque d'apparition d'un court-circuit entre des plots de contact d'entrée 1221 ou des branches du circuit de puissance 1220 associé à des phases électriques P1, P2, P3 et PN différentes, au niveau de la zone primaire du dispositif d'interconnexion 120, c'est-à-dire la zone se trouvant au voisinage des tensions primaires V1, s'en trouve considérablement réduit. La sécurité de l'unité 1 est de fait améliorée.

Les notions de distance dans l'air et de lignes de fuite sont bien connues de l'homme du métier et sont pas exemple définies plus en détail dans la norme IEC 60335 de la Commission Electrotechnique Internationale. Par exemple, la distance dans l'air correspond à la distance point à point entre deux contacts électriques alors que la ligne de fuite correspond à la distance la plus courte entre ces deux contacts électriques obtenus en cheminant le long des différents matériaux qui se trouvent entre ces deux contacts électriques

Ceci est assuré par le dimensionnement des écrans 1230. Grâce aux écrans 1230, et notamment de leur hauteur, par rapport aux dimensions du logement dans lequel le support 1210 du dispositif d'interconnexion 120 est reçu au sein du corps central 10, on évite la formation de lignes directes dans l'air entre deux plots de contact d'entrée 1221 consécutives puisque ces derniers sont électriquement séparés les uns des autres par les écrans 1230. De plus, grâce à la longueur de ces écrans 1230, la longueur des lignes de fuite permise au sein de cette face 1210A est supérieure ou égale à 28 mm ou à 32mm.

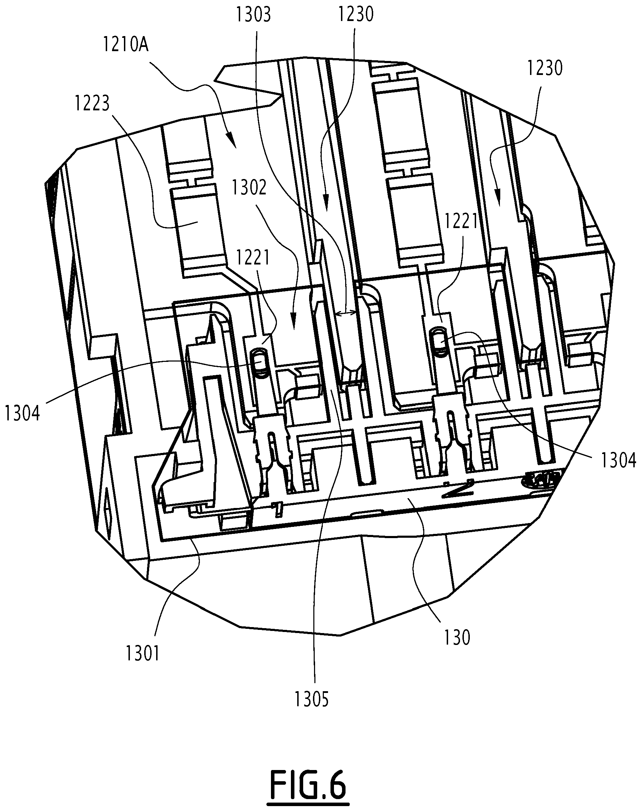

Comme illustré à la figure 6, le connecteur fil-à-carte 130 comporte un boîtier 1301 à l'intérieur duquel sont ménagés des logements 1302 distincts, séparés les uns des autres, sur une partie de leur longueur, par des espacements extérieurs 1303. Les espacements extérieurs 1303 sont de forme complémentaire aux extrémités des écrans d'isolement longitudinaux 1230.

Chacun des logements 1302 du connecteur 130 contient une lame de connexion électrique 1304, destinée à venir en contact avec un plot de contact d'entrée 1221 correspondant. Cette lame de contact 1304 est reliée électriquement à un câble électrique, lui-même raccordé électriquement à un terminal d'entrée de puissance correspondant du disjoncteur D.

Dans cet exemple, le connecteur 130 comporte quatre logements 1302, contenant chacun une lame 1304 chacun associé à une des phases électriques P1, P2, P3 et PN.

Le connecteur 130 comporte également des éléments d'alignement 1305, qui permettent le guidage et le positionnement du connecteur 130 sur le bort du support 1210.

Le connecteur 130 est amovible, c'est-à-dire qu'il est déplaçable, réversiblement et sélectivement, entre une position connectée et une position déconnectée.

Dans cet exemple, le connecteur 130, du fait notamment de sa forme, ne peut être inséré dans sa position connectée que s'il est orienté dans un sens prédéfini, assurant ainsi une fonction de détrompage.

Dans la configuration connectée, les extrémités des branches du support 1210 sont reçues à l'intérieur des logements correspondants 1302. Les plots de contact d'entrée 1210 placés sur ces extrémités des branches du support 1210 sont eux aussi reçues à l'intérieur des logements correspondants 1302 et sont en contact électrique avec les lames électriques 1304, de manière à assurer une connexion électrique avec les terminaux correspondant du disjoncteur D. Dans cette position connectée, les extrémités des écrans 1230 sont reçues à l'intérieur des espacements extérieurs 1303.

A la figure 6, pour faciliter la lecture, le boîtier 1301 n'est pas illustré en totalité et seul son contour extérieur est représenté schématisé par un trait continu.

Dans l'état déconnecté du connecteur 130, les extrémités des branches du support 1210 ainsi que les plots de contact d'entrée 1221, se situent à l'extérieur des logements 1302. De même, les lames 1304 sont déconnectées des plots de contact 1221, empêchant ainsi une connexion électrique entre les terminaux du disjoncteur D et le dispositif d'interconnexion 120.

Grâce à la disposition du connecteur 130, et notamment de l'interaction entre les espacements 1303 et les extrémités des écrans 1230, on allonge la longueur de la ligne de fuite qui doit être parcourue pour relier électriquement, dans l'air ambiant, les plots de contact d'entrée 1221. Cela réduit encore plus le risque de formation d'un court-circuit entre des plots de contact 1221 ou des lames 1304 adjacentes associées à des phases électriques P1, P2, P3. En particulier, la longueur L des lignes de fuite entre deux lames 1304 est ici supérieure ou égale à 28 mm ou, de préférence, à 32mm.

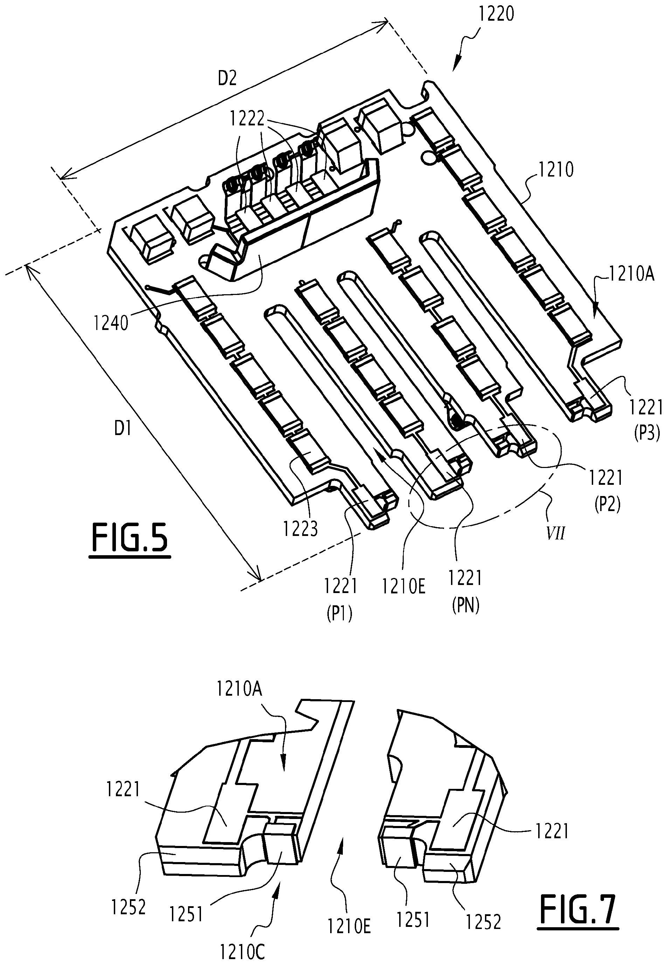

Avantageusement, le dispositif d'interconnexion 120 comporte également un mur d'isolement 1240, illustré à la figure 5, qui est intercalé contre les plots de contact d'entrée 1221 et les plots de contact de sortie 1222. Ce mur 1240 s'étend perpendiculairement par rapport à la face 1210A.

Le mur 1240 est ici réalisé en un matériau électriquement isolant, par exemple en matière plastique, telle que le polyamide réticulé PA 66, ou le polycarbonate chargé fibre de verre PC GF10 précédemment décrits.

Dans cet exemple, le mur 1240 est ménagé directement sur la face 1210A du support 1210, sur la partie principale du support 1210. Ce mur 1240 présente une partie centrale, de forme essentiellement plane, et des rabats latéraux inclinés par rapport à la partie centrale, de manière à entourer la zone de la face 1210A du support 1210 sur laquelle sont ménagés les contacts électriques 1222.

Par exemple, le mur 1240 présente une couleur claire, telle que du blanc ou du gris, pour faciliter sa détection automatique lors d'étapes de fabrication par un appareil de fabrication.

Le mur 1240 présente une hauteur, mesurée perpendiculairement à la surface de la face 1210A, c'est-à-dire perpendiculairement au plan géométrique P', qui est supérieure ou égal à 50% ou, de préférence à 80%, ou de préférence encore à 90%, de la distance libre entre la face 1210A et d'un couvercle recouvrant au moins partiellement cette face 1210A ce couvercle faisant partie du corps central 10.

Ainsi, lorsque le dispositif d'interconnexion 120 est dans une configuration assemblée au sein du corps central 10, le mur 1240 empêche la formation d'un arc électrique ou d'un court-circuit entre un des plots de contact d'entrée 1221 et l'un des plots de contact de sortie 1222. Cela est réalisé grâce au fait que le mur 1240 a une hauteur suffisante pour s'intercaler sur la ligne droite dans l'air ambiant reliant chacun des plots de contact d'entrée 1221 à chacun des plots de contact de sortie 1222. Ainsi, on assure un isolement électrique amélioré entre les tensions primaires et les tensions secondaires.

En effet, la conception modulaire de l'unité 1 permet d'assurer une bonne compacité et un encombrement de l'unité 1. Toutefois, une telle compacité de l'unité 1 introduit un risque de court-circuit entre les zones du dispositif d'interconnexion 120 qui sont exposées à la tension primaire V1 et les zones du dispositif d'interconnexion 120 qui sont exposées à la tension secondaire V2, car ces zones sont plus proches les unes des autres du fait de cette compacité.

Grâce au mur 1240, on allonge la distance qui doit être parcourue dans l'air ambiant pour relier électriquement, par exemple pour un arc électrique, entre ces deux zones. Cela réduit le risque d'apparition de tel court-circuit et augmente la sécurité électrique de l'unité 1.

En particulier, grâce au mur 1240, la distance dans l'air entre un plot de contact 1221 et un plot de contact 1222 est supérieure ou égale à 25 mm. De même, la distance de lignes de fuite entre un plot de contact d'entrée 1221 et un plot de contact 1222 est supérieure ou égale à 28 mm, de préférence à 32 mm. En variante, cette distance peut être différente, en fonction des matériaux utilisés pour former le support 1210 et le mur 1240.

Avantageusement, comme illustré à la figure 7, le support 1210 comporte des dorures 1251 en un matériau électriquement conducteur, tel que de l'or, qui sont ménagées sur une tranche 1210C perpendiculaire au bord latéral du support 1210. Cette tranche 1210C s'étend perpendiculairement aux faces 1210A et 1210B.

Chacune des dorures 1251 est reliée électriquement à un plot de contact d'entrée 1221 au moyen d'une piste électriquement conductrice ménagée sur la face 1210A. Ces dorures 1251 ont pour fonction de permettre un test du fonctionnement du circuit 1220 lors d'une étape de fabrication de l'unité 1. Ce test est typiquement réalisé au moyen d'appareil de test automatisé pour lequel le positionnement des dorures sur la tranche 1210 permet une connexion électrique plus aisée que de devoir se connecter aux plots de contact 1221.

Avantageusement, comme illustré à la figure 7, le support 1210 comporte des chanfreins 1252 ménagés sur des bords du support 1210 au niveau de la tranche 1210C. Ces chanfreins 1252 permettent un guidage et une fixation plus facile du connecteur 130.

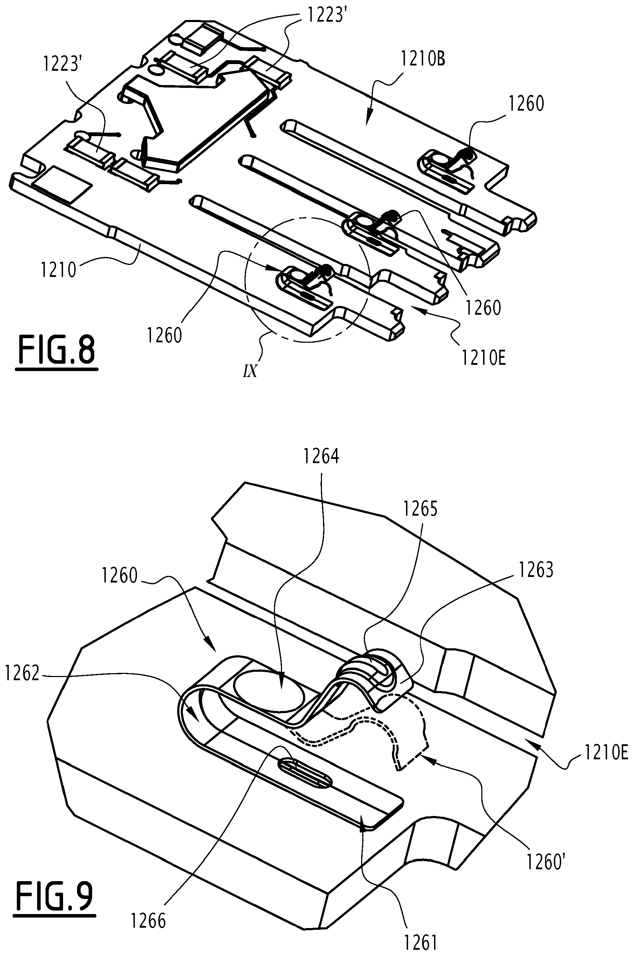

La figure 8 représente la deuxième face 1210B du dispositif d'interconnexion 120.

Le dispositif d'interconnexion 120 comporte des connecteurs électriques unitaires à lames souples 1260, adaptés pour assurer la connexion électrique entre le dispositif d'interconnexion 120 et l'interface d'interconnexion primaire 201 de module d'alimentation amovible 20 lorsque ce module d'alimentation amovible 20 est dans sa position insérée dans le corps central 10.

Dans cet exemple, le dispositif d'interconnexion 120 comporte trois connecteurs souples 1260, chacun associé à une des phases électriques P1, P2 et P3. En particulier, aucun connecteur souple 260 n'est associé à la phase neutre PN.

Chaque connecteur 1260 est fixé solidairement au support 1210, sur la deuxième face 1210B, au niveau d'une extrémité de la branche correspondante du support 1210. Le connecteur 1260 est par exemple soudé à la face 1210B du support 1210 au moyen d'une soudure ou d'un brasage.

Les connecteurs 1260 sont alignés entre eux et sont distants les uns des autres. De préférence, le connecteur 1260 situé au niveau des branches centrales est décalé selon la direction d'alignement des connecteurs 1260, de manière à ce qu'il ne soit pas placé trop près du connecteur 1260 immédiatement adjacent.

Chacun des connecteurs 1260 est relié électriquement au plot de contact d'entrée 1221 correspondant situés sur la face 1210A opposée, par exemple au moyen d'une connexion traversante ménagée au travers du support 1210.

Comme illustré à la figure 9, chaque connecteur 1260 comporte une base fixe 1261 solidarisée à la face 1210B du support 1210, une partie recourbée 1262, par exemple en forme de C, et une partie supérieure 1263 déformable.

La partie supérieure 1263 est déformable, de façon élastique et réversible, entre une position enfoncée et une position relâchée.

A la figure 9, le connecteur 1260 est illustré dans sa position de repos. Les traits pointillés 1260' représentent la position du contour de la partie supérieure 1263 lorsque celle-ci se trouve dans sa position enfoncée. Ici, le connecteur 1260 est dans la position enfoncée lorsque le module d'alimentation amovible 20 est dans la position insérée

La connexion avec l'interface de connexion primaire 201 du module d'alimentation 20 est réalisée par contact avec la partie supérieure 1263. Par exemple, l'interface de connexion primaire 201 du module d'alimentation 20 comporte une plaque rigide réalisée en un matériau électriquement conducteur. Lorsque le module d'alimentation 20 est en position inséré dans le corps central 10, chaque plaque de l'interface de connexion primaire 201 est appuyée sur la partie supérieure 1263, de façon à la déformer vers sa position enfoncée, pour assurer une conduction électrique.

Avantageusement, la partie recourbée 1262 comporte une zone plane 1264. Par exemple, ces dimensions de cette zone plane 1264 sont telles qu'on peut y inscrire un disque de diamètre supérieur ou égal à 2 mm. Une telle partie plane 1264 facilite la préhension du connecteur 1260 par une machine de pose automatique, ces dernières étant typiquement munies d'un organe de préhension équipé d'une buse d'aspiration ou d'une ventouse. Ainsi, le positionnement des connecteurs 1260 sur le support 1210 est simplifié, lors d'une étape de fabrication industrielle de l'unité 1.

Avantageusement, la partie supérieure 1263 comprend un bossage 1265 qui s'étend en saillie par rapport à la partie supérieure 1263, vers l'extérieur du connecteur 1260, c'est-à-dire à l'opposé de la base 1261.

Ce bossage 1265 permet d'assurer un meilleur contact électrique avec l'interface de connexion primaire 201, notamment pour assurer un contact électrique ponctuel. On réduit ainsi le risque de faux contact et donc de dysfonctionnement du module d'alimentation 20. Ainsi, la fiabilité de l'unité 1 est augmentée.

Avantageusement, la base 1261 comporte un orifice oblong traversant 1266 qui présente une circonférence supérieure ou égale à 4.5 mm.

Un tel orifice 1266 permet d'assurer une remontée du matériau de soudure ou de brasage utilisé pour souder le connecteur 1260 au support 1210. Ce matériau remonte ainsi sur les parois de l'orifice 1266 jusque sur une face supérieure de la base 1261. La qualité du contact électrique entre le connecteur 1260 et le plot de contact d'entrée 1221 s'en trouve ainsi améliorée.

Le connecteur 1260 est ici réalisé en matière métallique, de préférence dans un alliage de cuivre béryllium. Un tel alliage de cuivre béryllium présente l'avantage d'assurer une bonne élasticité, tout en ayant des propriétés électriquement conductrices satisfaisantes. Du fait de cette bonne élasticité, on limite le risque de déformation plastique, c'est-à-dire irréversible, de la partie supérieure 1263 lorsque celle-ci est assujettie à des déformations importantes et répétées entre ces deux positions. Ainsi, la durabilité et la fiabilité de l'unité 1 s'en trouvent améliorées.

Grâce aux connecteurs 1260, il n'est pas nécessaire d'avoir recours à des connexions filaires ni à des connecteurs à broches pourvus de boîtiers volumineux pour assurer la connexion du module 20.

De façon générale, grâce au dispositif d'interconnexion 120, les connexions électriques au sein du corps central 10 sont réalisées soit grâce à des pistes électriquement conductrices ménagées sur des supports, soit grâce des connecteurs unitaires. Il n'est donc pas nécessaire d'utiliser des fils ou des connexions câblées au sein de l'unité 1. Cela réduit d'une part son encombrement, et d'autre part permet d'assurer une structure modulaire, dans laquelle des modules peuvent être sélectivement retirés pour ajouter de façon simplifiée par un utilisateur de l'unité 1 au cours du fonctionnement de l'unité 1 sans qu'il ne soit nécessaire de modifier à chaque fois le câblage.

Ces connecteurs sont également adaptés pour supporter un nombre élevé de cycle d'insertion et de retrait des différents modules, assurant une longévité satisfaisante de l'unité 1.

Dans cet exemple, l'unité 1 comporte en outre un module de configuration 30, un module interface utilisateur 40, un module de détection de court-circuit 50, un module additionnel 60 et un couvercle 70. Dans cet exemple, chacun de ces modules comporte une carte électronique et des connecteurs de type à piston pour réaliser les liaisons de données et/ou d'alimentation électrique avec le dispositif de commande du corps central 10.

On note 41, 51, 61 des cartes électroniques associées au module, respectivement, 40, 50 et 60. Ces cartes électroniques sont ici disposées parallèlement au plan P lorsque l'unité de contrôle 1 est dans une configuration assemblée. Le module 30 comporte également ici une carte électronique, non illustrée. Avantageusement, le module 50 comporte un écran électriquement isolant 53 qui recouvre la carte électronique 51. Cela permet de protéger cette carte électronique 51 lorsque le module 50 est retiré hors du corps central 10, tout en ayant un encombrement moindre qu'un boîtier plastique.

Les modes de réalisation et les variantes envisagés ci-dessus peuvent être combinés entre eux pour générer de nouveaux modes de réalisation.

## Revendications

1. Unité de contrôle (1) d'un disjoncteur électrique (D) multipolaire, ladite unité comportant:
- un corps central (10) incluant:
• un dispositif d'interconnexion (120) comprenant:
∘ des plots de contact d'entrée (1221) apte à être raccordées électriquement à des terminaux d'entrée de puissance d'un disjoncteur électrique multipolaire (D), pour recevoir des tensions électriques primaires (V1) depuis le disjoncteur,
∘ un circuit électrique de puissance (1220) incluant un pont diviseur de tension, configuré pour convertir les tensions électriques primaires (V1) en des tensions électriques secondaires (V2);
• un dispositif de commande (110), pourvu d'un circuit de mesure (1101) apte à mesurer les tensions électriques secondaires (V2) fournies par le circuit électrique de puissance (1220), le dispositif de commande (110) étant programmé pour déterminer un état de fonctionnement du disjoncteur (D) en fonction des tensions électriques secondaires mesurées par le circuit de mesure (1101);
- un module d'alimentation électrique (20) amovible, reçu dans un logement du corps central (10), ce module:
• étant raccordé électriquement au dispositif d'interconnexion (120) pour collecter les tensions électriques primaires (V1), et
• comprenant un convertisseur de puissance (203), configuré pour transformer les tensions électriques primaires (V1) collectées en une tension électrique secondaire supplémentaire (V2') et pour alimenter électriquement un bus commun d'alimentation électrique (1102) du dispositif de commande (110) avec cette tension électrique secondaire supplémentaire (V2'),
l'unité de contrôle (1) étant conçue de manière à ce que le module d'alimentation électrique (20) puisse être retiré sans impacter le fonctionnement du dispositif de commande (110).

2. Unité de contrôle (1) selon la revendication 1, **caractérisée en ce que** le dispositif d'interconnexion ( 120) comporte un support (1210) sur lequel le circuit électrique de puissance (1220) est ménagé, les plots de contact d'entrée (1221) étant disposés au niveau d'un bord du support, et **en ce que** le dispositif d'interconnexion (120) comporte des écrans d'isolement longitudinaux (1230) arrangés le long du support (1210) en partant depuis ledit bord du support et en s'étendant perpendiculairement par rapport au plan (P') du support (1210), pour séparer transversalement les plots de contacts d'entrée (1221) les uns des autres.

3. Unité de contrôle (1) selon la revendication 2, **caractérisée en ce que** les écrans d'isolement longitudinaux s'étendent sur au moins 50% de la longueur (D1) du support (1210).

4. Unité de contrôle (1) selon l'une quelconque des revendications 2 ou 3, **caractérisée en ce que** le pont diviseur comporte des résistances électriques (1223) reliées électriquement entre elles, le long de rangées pour former des branches distinctes du circuit électrique de puissance (1220), chaque branche étant associée à une phase électrique (P1, P2, P3, PN), et **en ce que** les écrans d'isolement longitudinaux (1230) s'étendent parallèlement aux rangées de résistances pour séparer transversalement ces branches les unes des autres.

5. Unité de contrôle (1) selon l'une quelconque des revendications 2 à 4, **caractérisée en ce que** l'unité (1) comporte un connecteur fil-à-carte (130) amovible pour raccorder électriquement les plots de contact d'entrée (1221) à des câbles électriques aptes à être raccordés électriquement à des terminaux d'entrée de puissance du disjoncteur, ce connecteur fil-à-carte (130) comportant un boîtier (1301) dans lequel sont ménagés des logements (1302), à l'intérieur desquels sont reçus les plots de contact d'entrée (1221) lorsque le connecteur est dans une position connectée au dispositif d'interconnexion (120), ces logements (1302) étant séparés les uns des autres sur une partie de leur longueur par des espacements extérieurs (1303) de forme complémentaire aux écrans d'isolement longitudinaux (1230).

6. Unité de contrôle (1) selon l'une quelconque des revendications précédentes, **caractérisée en ce que** le dispositif d'interconnexion (120) comporte :
- des plots de contact de sortie (1222) du circuit électrique de puissance, ménagés sur une même face (1210A) du support (1210) que les plots de contact d'entrée, et
- un mur d'isolement (1240) intercalé entre les plots de contact d'entrée (1221) et les plots de contact de sortie (1222) et s'étendant perpendiculairement à ladite face (1210A).

7. Unité de contrôle selon l'une quelconque des revendications précédentes, **caractérisée en ce que** le dispositif d'interconnexion (120) comporte des connecteurs électriques unitaires à lame souple (1260) adaptés pour être raccordés électriquement à une interface de connexion primaire (201) du module d'alimentation amovible (20).

8. Unité de contrôle selon la revendication 7, **caractérisée en ce que** les connecteurs unitaires à lame souple (1260) sont réalisés en un alliage de Cuivre ― Béryllium.

9. Unité de contrôle (1) selon l'une quelconque des revendications précédentes, **caractérisée en ce qu'**il comporte des modules additionnels amovibles (30, 40, 50, 60) aptes à être raccordés électriquement au dispositif de commande, l'unité de contrôle comportant à cet effet des connecteurs électriques à pistons adaptés pour être connectés à des connecteurs correspondants équipant ces modules additionnels.

10. Disjoncteur électrique multipolaire, comportant une unité de contrôle (1) du disjoncteur, **caractérisé en ce que** l'unité de contrôle (1) est selon l'une quelconque des revendications précédentes, le dispositif d'interconnexion (120) étant raccordé électriquement à des terminaux de puissance du disjoncteur (D).

## Patentansprüche

1. Steuereinheit (1) für einen mehrpoligen elektrischen Leistungsschalter (D), wobei die Einheit umfasst
- einen Mittelkörper (10), einschließend:
• eine Verbindungsvorrichtung (120), umfassend:
o Eingangskontaktanschlüsse (1221), die geeignet sind, elektrisch mit Leistungseingangsklemmen eines mehrpoligen elektrischen Leistungsschalters (D) verbunden zu werden, um elektrische Primärspannungen (V1) von dem Leistungsschalter zu empfangen,
o einen elektrischen Leistungsschaltkreis (1220) mit einer Spannungsteilerbrücke, der ausgebildet ist, die elektrischen Primärspannungen (V1) in elektrische Sekundärspannungen (V2) umzuwandeln;
• eine Steuervorrichtung (110), die mit einem Messschaltkreis (1101) versehen ist, der geeignet ist, die von dem elektrischen Leistungsschaltkreis (1220) gelieferten elektrischen Sekundärspannungen (V2) zu messen, wobei die Steuervorrichtung (110) programmiert ist, einen Betriebszustand des Leistungsschalters (D) in Abhängigkeit von den von dem Messschaltkreis (1101) gemessenen elektrischen Sekundärspannungen zu bestimmen;
- ein entfernbares Energieversorgungsmodul (20), das in einem Aufnahmeraum des Mittelkörpers (10) aufgenommen ist, wobei dieses Modul:
• elektrisch mit der Verbindungsvorrichtung (120) verbunden ist, um die elektrischen Primärspannungen (V1) abzugreifen, und
• einen Leistungswandler (203) umfasst, der ausgebildet ist, die abgegriffenen elektrischen Primärspannungen (V1) in eine zusätzliche elektrische Sekundärspannung (V2') umzuwandeln und einen gemeinsamen Bus (1102) der elektrischen Energieversorgung der Steuervorrichtung (110) mit dieser zusätzlichen elektrischen Sekundärspannung (V2') elektrisch zu versorgen, wobei die Steuereinheit (1) derart ausgebildet ist, dass das Energieversorgungsmodul (20) ohne Beeinträchtigung des Betriebs der Steuervorrichtung (110) entfernt werden kann.

2. Steuereinheit (1) nach Anspruch 1, **dadurch gekennzeichnet, dass** die Verbindungsvorrichtung (120) einen Träger (1210) umfasst, auf dem der elektrische Leistungsschaltkreis (1220) vorgesehen ist, wobei die Eingangskontaktanschlüsse (1221) an einem Rand des Trägers angeordnet sind, und dadurch, dass die Verbindungsvorrichtung (120) längsgerichtete Isolationsabschirmungen (1230) umfasst, die entlang des Trägers (1210) ausgehend von dem Rand des Trägers angeordnet sind und sich senkrecht in Bezug auf die Ebene (P') des Trägers (1210) erstrecken, um die Eingangskontaktanschlüsse (1221) in Querrichtung voneinander zu trennen.

3. Steuereinheit (1) nach Anspruch 2, **dadurch gekennzeichnet, dass** sich die längsgerichteten Isolationsabschirmungen über mindestens 50% der Länge (D1) des Trägers (1210) erstrecken.

4. Steuereinheit (1) nach einem beliebigen der Ansprüche 2 oder 3, **dadurch gekennzeichnet, dass** die Teilerbrücke elektrische Widerstände (1223) aufweist, die entlang von Reihen elektrisch miteinander verbunden sind, um verschiedene Zweige des elektrischen Leistungsschaltkreises (1220) zu bilden, wobei jeder Zweig einer elektrischen Phase (P1, P2, P3, PN) zugeordnet ist, und dadurch, dass sich die längsgerichteten Isolationsabschirmungen (1230) parallel zu den Reihen von Widerständen erstrecken, um diese Zweige in Querrichtung voneinander zu trennen.

5. Steuereinheit (1) nach einem beliebigen der Ansprüche 2 bis 4, **dadurch gekennzeichnet, dass** die Einheit (1) einen abnehmbaren Wire-to-Board Verbinder (130) zum elektrischen Verbinden der Eingangskontaktanschlüsse (1221) mit elektrischen Kabeln umfasst, die geeignet sind, elektrisch mit Leistungseingangsklemmen des Leistungsschalters verbunden zu werden, wobei der Wire-to-Board Verbinder (130) ein Gehäuse (1301) aufweist, in dem Aufnahmeräume (1302) vorgesehen sind, in denen die Eingangskontaktanschlüsse (1221) aufgenommen werden, wenn sich der Verbinder in einer mit der Verbindungsvorrichtung (120) verbundenen Position befindet, wobei diese Aufnahmeräume (1302) über einen Teil ihrer Länge durch äußere Abstandshalter (1303) in komplementärer Form zu den längsgerichteten Isolationsabschirmungen (1230) voneinander getrennt sind.

6. Steuereinheit (1) nach einem beliebigen der vorhergehenden Ansprüche, **dadurch gekennzeichnet, dass** die Verbindungsvorrichtung (120) umfasst:
- Ausgangskontaktanschlüsse (1222) des elektrischen Schaltkreises, die auf einer gleichen Fläche (1210A) des Trägers (1210) wie die Eingangskontaktanschlüsse vorgesehen sind, und
- eine Isolationswand (1240), die zwischen den Eingangskontaktanschlüssen (1221) und den Ausgangskontaktanschlüssen (1222) angeordnet ist und sich senkrecht zu der genannten Fläche (1210A) erstreckt.

7. Steuereinheit nach einem beliebigen der vorhergehenden Ansprüche, **dadurch gekennzeichnet, dass** die Verbindungsvorrichtung (120) einheitliche elektrische Verbindungselemente (1260) mit flexiblem Kontaktstreifen umfasst, die geeignet sind, mit einer primären Verbindungsschnittstelle (201) des entfernbaren Versorgungsmoduls (20) elektrisch verbunden zu werden.

8. Steuereinheit nach Anspruch 7, **dadurch gekennzeichnet, dass** die einheitlichen Verbindungselemente (1260) mit flexiblem Kontaktstreifen aus einer Kupfer-Beryllium-Legierung hergestellt sind.

9. Steuereinheit (1) nach einem beliebigen der vorhergehenden Ansprüche, **dadurch gekennzeichnet, dass** sie entfernbare Zusatzmodule (30, 40, 50, 60) aufweist, die geeignet sind, mit der Steuervorrichtung elektrisch verbunden zu werden, wobei die Steuereinheit zu diesem Zweck elektrische Verbindungselemente mit Kolben umfasst, die geeignet sind, mit entsprechenden Verbindungselementen verbunden zu werden, die diese Zusatzmodule ausrüsten.

10. Mehrpoliger elektrischer Leistungsschalter, der eine Steuereinheit (1) des Leistungsschalters aufweist, **dadurch gekennzeichnet, dass** die Steuereinheit (1) nach einem beliebigen der vorhergehenden Ansprüche ausgebildet ist, wobei die Verbindungsvorrichtung (120) elektrisch mit Leistungsklemmen des Leistungsschalters (D) verbunden ist.

## Claims

1. Control unit (1) for a multipole electrical circuit breaker (D), said unit comprising:
- a central body (10) including:
• an interconnect device (120) comprising:
o input contact pads (1221) capable of being electrically connected to power input terminals of a multipole electrical circuit breaker (D) in order to receive primary electrical voltages (V1) from the circuit breaker,
o an electrical power circuit (1220) including a voltage divider bridge, configured to convert the primary electrical voltages (V1) into secondary electrical voltages (V2);
• a control device (110) provided with a measuring circuit (1101) capable of measuring the secondary electrical voltages (V2) provided by the electrical power circuit (1220), the control device (110) being programmed to determine an operating state of the circuit breaker (D) as a function of the secondary electrical voltages (V2) measured by the measuring circuit (1101);
- a removable power supply module (20) received in a housing of the central body (10), the module:
• being electrically connected to the interconnect device (120) in order to collect the primary electrical voltages (V1), and
• comprising a power converter (203) configured to transform the collected primary electrical voltages (V1) into a supplementary secondary electrical voltage (V2') and to supply power to a shared power supply bus (1102) of the control device (110) using the supplementary secondary electrical voltage (V2'),
the control unit (1) being designed so that the power supply module (20) can be removed without affecting the operation of the control device (110).

2. Control unit (1) according to claim 1, **characterised in that** the interconnect device (120) comprises a support (1210) on which the electrical power circuit (1220) is formed, the input connection pads (1221) being arranged in the region of an edge of the support, and **in that** the interconnect device (120) comprises longitudinal insulating screens (1230) arranged along the support (1210) starting from said edge of the support and extending perpendicularly relative to the plane (P') of the support (1210), in order to transversely separate the input contact pads (1221) from one another.

3. Control unit (1) according to claim 2, **characterised in that** the longitudinal insulating screens extend over at least 50% of the length (D1) of the support (1210).

4. Control unit (1) according to either claim 2 or claim 3, **characterised in that** the divider bridge comprises electrical resistors (1223) which are electrically connected together along rows to form distinct branches of the electrical power circuit (1220), each branch being associated with an electrical phase (P1, P2, P3, PN), and **in that** the longitudinal insulating screens (1230) extend parallel to the rows of resistors in order to transversely separate the branches from one another.

5. Control unit (1) according to any one of claims 2 to 4, **characterised in that** the unit (1) comprises a removable wire-to-board connector (130) for electrically connecting the input contact pads (1221) to electric cables which are capable of being electrically connected to power input terminals of the circuit breaker, the wire-to-board connector (130) comprising a case (1301) in which there are formed housings (1302) inside which the input contact pads (1221) are received when the connector is in a position connected to the interconnect device (120), the housings (1302) being separated from one another over a portion of their length by external spacings (1303) having a shape complementary to the longitudinal insulating screens (1230).

6. Control unit (1) according to any one of the preceding claims, **characterised in that** the interconnect device (120) comprises:
- output contact pads (1222) of the electrical power circuit which are formed on the same face (1210A) of the support (1210) as the input contact pads, and
- an insulating wall (1240) which is interposed between the input contact pads (1221) and the output contact pads (1222) and extends perpendicularly to said face (1210A).

7. Control unit according to any one of the preceding claims, **characterised in that** the interconnect device (120) comprises one-piece spring-leaf electrical connectors (1260) which are adapted to be electrically connected to a primary connection interface (201) of the removable power supply module (20).

8. Control unit according to claim 7, **characterised in that** the one-piece spring-leaf connectors (1260) are made of a copper-beryllium alloy.

9. Control unit (1) according to any one of the preceding claims, **characterised in that** it comprises additional removable modules (30, 40, 50, 60) capable of being electrically connected to the control device, the control unit comprising for this purpose piston-type electrical connectors adapted to be connected to corresponding connectors provided on the additional modules.

10. Multipole electrical circuit breaker, comprising a control unit (1) for the circuit breaker, **characterised in that** the control unit (1) is in accordance with any one of the preceding claims, the interconnect device (120) being electrically connected to power terminals of the circuit breaker (D).
